# EUROPÄISCHE PATENTANMELDUNG

(11) **EP 2 006 695 A1**
(43) Veröffentlichungstag der Anmeldung: **24.12.2008**
(21) Anmeldenummer: 08010896.2
(22) Anmeldetag: 16.06.2008
(51) Int. Cl.: G01R 31/24, G01R 31/44

(54) **Prüfgerät für Leuchtmittel**

(30) Priorität: 22.06.2007 DE 102007029230
(71) Anmelder: Hoover Dam Technology GmbH, 79286 Glottertal (DE)
(72) Erfinder: Andresen, Michael, 78112 Sankt Georgen (DE); Schwär, Markus, 79271 Sankt Peter (DE); Herr, Jürgen, 79215 Elzach-Yach (DE)
(74) Vertreter: Patentanwälte Westphal, Mussgnug & Partner

(57) **Zusammenfassung**

Prüfgerät (1) für Leuchtmittel (3), die bei einer Nennspannung (Vₙ) und einer Nennfrequenz (fₙ) betrieben werden, mit kapazitiver Ankopplung einer Prüfspannung (Vₚ) mit einer Prüffrequenz (fₚ) an die Leuchtmittel (3), wobei eine angekoppelte Prüfspannung (Vₚₐ) der Nennspannung (vₙ) entspricht und eine angekoppelte Prüffrequenz (fₚₐ) der Nennfrequenz (fₙ) entspricht.

## Beschreibung

Die Erfindung betrifft ein Prüfgerät für Leuchtmittel gemäß oberbegrifflichen Merkmalen des Patentanspruchs 1.

Aus dem Stand der Technik sind verschiedene Prüfgeräte für Leuchtmittel bekannt.

Die US 3,688,185 zeigt z. B. ein Prüfgerät für Leuchtstoffröhren, dem zwei unterschiedliche Messprinzipien zugrunde liegen. Zum einen weist dieses Prüfgerät eine Vorrichtung zur Durchgangsprüfung der Heizwendel der Leuchtstofflampe auf, durch die überprüft wird, ob über die Heizwendel der Leuchtstofflampe ein leitender Kontakt hergestellt werden kann. Zum anderen ist eine Spule vorgesehen, mittels derer ein hochfrequentes elektromagnetisches Feld in die Leuchtstoffröhre eingekoppelt werden kann, um zu überprüfen, ob eine ausreichende Gasfüllung der Leuchtstoffröhre vorhanden ist. Wenn eine ausreichende Gasfüllung der Leuchtstoffröhre vorhanden ist, so wird diese durch das hochfrequente elektromagnetische Feld ausreichend angeregt, um die Leuchtstoffröhre zumindest abschnittsweise zum Leuchten zu bringen.

Die US 5,047,721 beschreibt eine Vorrichtung zur Ermittlung einer fehlerhaften Lampe in einer Lichterkette mit einer Vielzahl von in Reihe geschalteten Lampen, bei der durch eine kapazitive Ankopplung des Prüfgeräts eine an einer defekten Lampe anliegende Spannung detektiert wird.

Nachteilhaft an den bekannten Prüfgeräten ist, dass eine Überprüfung von Leuchtmitteln mit integrierter VorschaltElektronik nicht möglich ist. So ist es z. B. mit den Prüfgeräten aus dem Stand der Technik nicht möglich, sogenannte Stromsparlampen, die ein integriertes elektronisches Vorschaltgerät aufweisen, vollständig zu überprüfen.

Ausgehend vom Stand der Technik liegt der Erfindung die Aufgabe zugrunde, ein Prüfgerät für Leuchtmittel zur Verfügung zu stellen, das es auf kostengünstige und sichere Art und Weise ermöglicht, sowohl konventionelle Glühlampen als auch Leuchtstofflampen mit integrierter Vorschaltelektronik zu überprüfen.

Diese Aufgabe wird gelöst durch ein Prüfgerät für Leuchtmittel mit den Merkmalen des Patentanspruchs 1.

Weitere vorteilhafte Ausgestaltungsformen sind Gegenstand der Unteransprüche.

Erfindungsgemäß wird ein Prüfgerät für Leuchtmittel, die bei einer Nennspannung und bei einer Nennfrequenz betrieben werden, vorgeschlagen, wobei eine kapazitive Ankopplung einer Prüfspannung mit einer Prüffrequenz an die Leuchtmittel erfolgt und wobei eine angekoppelte Prüfspannung der Nennspannung entspricht und eine angekoppelte Prüffrequenz der Nennfrequenz entspricht.

Das erfindungsgemäße Prüfgerät hat damit den Vorteil, dass die Überprüfung der Leuchtmittel bei der Nennspannung und der Nennfrequenz des Leuchtmittels durchgeführt wird und somit eine Überprüfung unter Betriebsbedingungen stattfinden kann. Dadurch, dass an ein Leuchtmittel, beispielsweise eine Energiesparlampe, eine Spannung von beispielsweise 230 V bei einer Frequenz von beispielsweise 50 Hz angekoppelt wird, ist es möglich, die Energiesparlampe in ihrer Gesamtheit, also Vorschaltelektronik, Heizwendel und Gasfüllung, zu überprüfen. Es wird somit ausgeschlossen, dass zwar die Gasfüllung der Energiesparlampe in Ordnung ist, aber die Lampe trotzdem aufgrund eines Fehlers in der Vorschaltelektronik als defekt zu bewerten wäre.

In einer bevorzugten Ausgestaltungsform des Prüfgeräts erfolgt die kapazitive Ankopplung der Prüfspannung über isolierte Kontaktflächen.

Eine isolierte Ausführung der Kontaktflächen zur kapazitiven Ankopplung hat den Vorteil, dass eine Berührung der Kontaktflächen verhindert wird und elektrische Schläge für einen Benutzer und ein Kurzschließen der Kontaktflächen verhindert werden. Es ist daher möglich, ein derart ausgestaltetes Prüfgerät beispielsweise in einem Ausstellungsraum eines Ladengeschäfts frei zugänglich zur Überprüfung von Lampen aufzustellen. Es ist aber auch möglich beispielsweise eine oder beide Kontaktflächen berührbar auszuführen. Bei Verwendung eines Netztrenntransformators zur Erzeugung der Prüfspannung ist trotzdem eine berührungssichere Funktion gewährleistet.

Gemäß einer bevorzugten Weiterbildung des erfindungsgemäßen Prüfgeräts ist eine Messvorrichtung zur Messung der angekoppelten Prüfspannung und eine Regelungsvorrichtung zur Regelung der Prüfspannung durch einen Vergleich einer gemessenen Prüfspannung mit einer Referenzspannung vorgesehen.

Eine derartige Ausgestaltung hat den Vorteil, dass durch die Messung der angekoppelten Prüfspannung und die Regelung der Prüfspannung eine Kompensation von Verlusten, die durch die kapazitive Ankopplung der Prüfspannung entstehen, möglich ist. Bevorzugterweise erfolgt die Messung der angekoppelten Prüfspannung durch eine kapazitive Messvorrichtung.

Es ist des Weiteren vorteilhaft, wenn eine Detektionsvorrichtung zur Detektion des Leuchtmittels vorgesehen ist.

Durch die Detektionsvorrichtung ist es beispielsweise möglich, das Prüfgerät derart auszugestalten, dass durch eine geringe Prüfspannung, die nicht der Nennspannung der zu überprüfenden Leuchtmittel entspricht, das Einführen eines Leuchtmittels in das Prüfgerät erkannt wird und erst bei eingeführtem Leuchtmittel die Prüfspannung und die Prüffrequenz auf das Niveau der Nennspannung und der Nennfrequenz geregelt werden. Das erfindungsgemäße Prüfgerät ist durch diese Maßnahme besonders energiesparend auslegbar.

Gemäß einer weiteren Ausgestaltungsform des erfindungsgemäßen Prüfgeräts ist eine Änderungsvorrichtung vorgesehen, die die Prüfspannung in einem Spannungsbereich und/oder die Prüffrequenz in einem Frequenzbereich verändert.

Durch die derartige Änderungsvorrichtung ist es möglich, die Leuchtmittel in einem Spannungsbereich und/oder einem Frequenzbereich zu überprüfen und so festzustellen, ob beispielsweise bei Schwankungen der Spannung und/oder der Frequenz eines Stromversorgungsnetzes mit Ausfällen der Leuchtmittel gerechnet werden muss.

In einer bevorzugten Weiterbildung des Prüfgeräts ist eine Erzeugungsvorrichtung zur Erzeugung der Prüfspannung aus einer Niedervolt-Energieversorgung vorgesehen. Die Erzeugungsvorrichtung kann beispielsweise einen Transformator oder einen Gleichspannungswandler beinhalten.

Eine derartige Ausgestaltung des Prüfgeräts hat den Vorteil, dass als Niedervolt-Energieversorgung beispielsweise eine Batterie oder ein Akkumulator dienen kann und so ein mobiler Einsatz des Prüfgeräts möglich ist. Der Einsatz eines Gleichspannungswandlers zur Erzeugung der Prüfspannung bringt gegenüber dem Einsatz eines Transformators des Weiteren einen Gewichtsvorteil.

Vorteilhafterweise ist zur Bereitstellung der Prüffrequenz ein Taktgenerator vorgesehen.

Eine derartige Ausgestaltung des Prüfgeräts hat den Vorteil, dass durch einen Taktgenerator in sehr platzsparender Weise eine exakte Einstellung der Prüffrequenz möglich ist.

Weitere bevorzugte Ausgestaltungsformen und vorteilhafte Weiterbildungen der Erfindung ergeben sich aus der nachfolgenden Beschreibung von Ausführungsbeispielen unter Bezugnahme auf die beigefügten Figuren.

Es zeigen:
- Figur 1: ein Blockschaltbild eines erfindungsgemäßen Prüfgeräts,
- Figur 2: ein erstes Ausführungsbeispiel des Prüfgeräts mit einem Transformator und
- Figur 3: ein zweites Ausführungsbeispiel des Prüfgeräts mit einem Gleichspannungswandler.

In den Figuren bezeichnen, soweit nicht anders angegeben, gleiche Bezugszeichen identische oder funktionsgleiche Baugruppen.

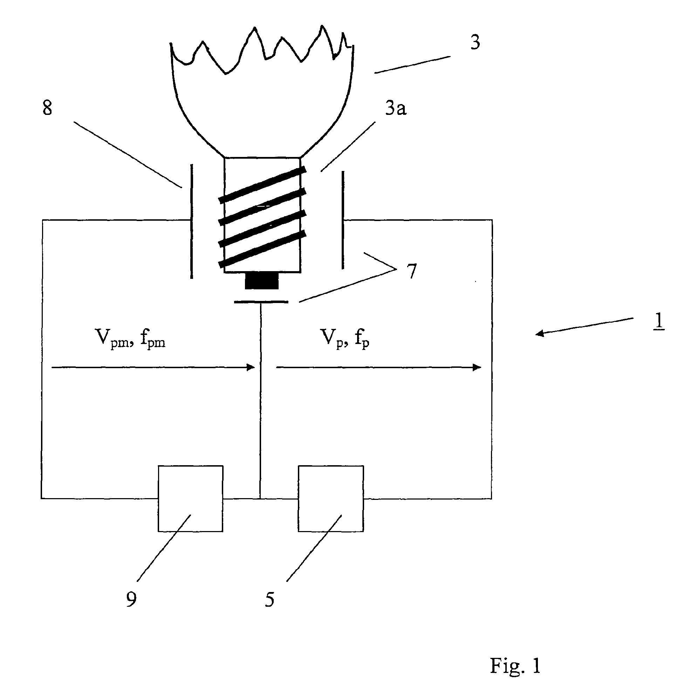

Figur 1 zeigt ein vereinfachtes Blockschaltbild eines erfindungsgemäßen Prüfgeräts 1 für Leuchtmittel 3. Das Prüfgerät 1 besteht im Wesentlichen aus einer Bereitstellungsvorrichtung 5 zur Bereitstellung einer Prüfspannung Vₚ mit einer Prüffrequenz f_{P}. Die Prüfspannung Vₚ ist an isolierte Kontaktflächen 7 anlegbar. Die Kontaktflächen 7 sind geeignet angeordnet, dass eine kapazitive Ankopplung der Prüfspannung Vₚ an einen Sockel 3a des Leuchtmittels 3 ermöglicht wird. Eine angekoppelte Prüfspannung Vₚₐ ist auf Grund von Verlusten bei der kapazitiven Auskopplung kleiner als die Prüfspannung Vₚ, d. h., dass die Ausgangsspannung der Bereitstellungsvorrichtung 5 entsprechend größer gewählt werden muss, damit die angekoppelte Prüfspannung Vₚₐ der Nennspannung Vₙ entspricht. Wie in Figur 1 dargestellt, weist das Prüfgerät des Weiteren eine Messvorrichtung 8 zur Messung der angekoppelten Prüfspannung Vₚₐ auf. Die Messvorrichtung 8 ist als kapazitive Messvorrichtung mittels einer weiteren Kontaktfläche ausgeführt und stellt an ihrem Ausgang eine gemessene Prüfspannung Vₚₘ zur Verfügung. Die gemessene Prüfspannung Vₚₘ ist auf Grund der oben angesprochenen Verluste, die auch beim kapazitiven Abgriff der Spannung entstehen kleiner als die angekoppelte Prüfspannung Vₚₐ. Die gemessene Prüfspannung Vₚₘ ist einer Regelungsvorrichtung 9 zuführbar, durch die eine Regelung der Prüfspannung Vₚ möglich ist. Die Regelung der Prüfspannung Vₚ kann alternativ auch über die Messung eines ausgangsseitigen Stroms der Bereitstellungsvorrichtung 5 erfolgen. Ein kapazitiver Abgriff der angekoppelten Prüfspannung Vₚₐ kann dann entfallen. Bei Verwendung eines Netztrenntransformators zur Bereitstellung der Prüfspannung Vₚ ist es auch denkbar eine oder beide Kontaktflächen 7 berührbar auszugestalten. Ein berührungssicherer Betrieb wird durch den Netztransformator gewährleistet.

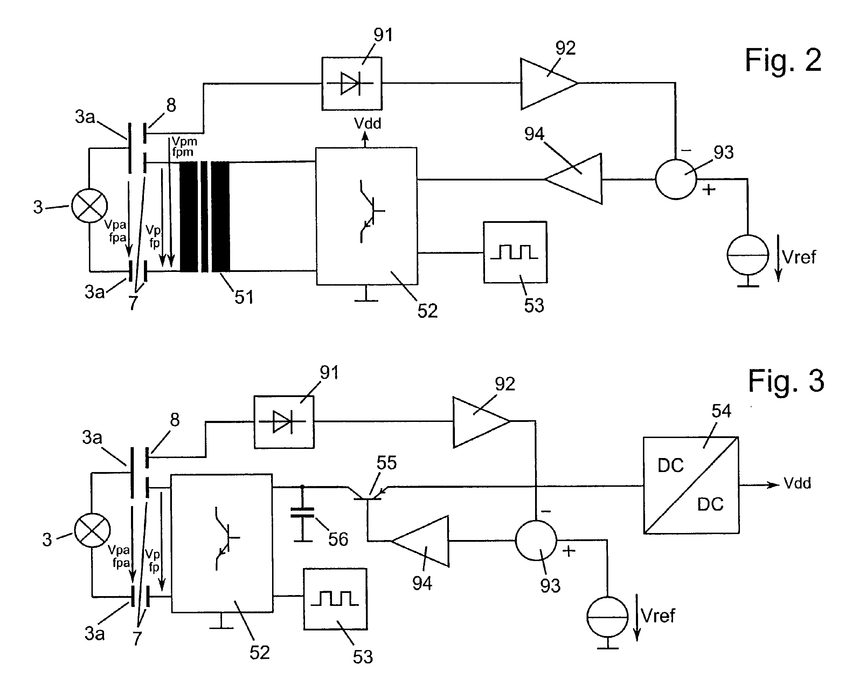

Figur 2 zeigt ein erstes Ausführungsbeispiel des erfindungsgemäßen Prüfgeräts, wobei die Erzeugungsvorrichtung 5 einen Transformator 51 zur Erzeugung der Prüfspannung Vₚ aufweist. Die Prüfspannung Vₚ ist ausgangsseitig am Transformator 51 abgreifbar und den Kontaktflächen 7 zuführbar. Durch die Kontaktflächen 7 ist die Prüfspannung Vₚ an den Sockel 3a des Leuchtmittels 3 ankoppelbar. Durch die Messvorrichtung 8 wird die angekoppelte Prüfspannung Vₚₐ abgegriffen und die gemessene Prüfspannung Vₚₘ zur Verfügung gestellt und einem Regelzweig zugeführt. Die gemessene Prüfspannung Vₚₘ weist eine gemessene Frequenz fₚₘ auf. Im Regelzweig wird die gemessene Prüfspannung Vₚₘ zur Erzeugung einer Gleichspannung einem Gleichrichter 91 und anschließend einem Verstärker 92 zugeführt. Das ausgangsseitige Signal des Verstärkers 92 wird mit negativem Vorzeichen einer Summationsstelle 93 zugeführt, der gleichzeitig eine Referenzspannung V_{ref} zugeführt wird. Das ausgangsseitige Signal der Summationsstelle 93 wird einem zweiten Verstärker 94 zugeführt, dessen ausgangsseitiges Signal einer Treiberstufe 52 als Steuersignal zuführbar ist. Der Treiberstufte 52 ist des Weiteren ein Taktsignal von einem Taktgenerator 53 zuführbar. Das Taktsignal hat eine der Prüffrequenz fp identische Frequenz. Die Treiberstufe 52 ist des Weiteren an die Versorgungsspannung V_{dd} angeschlossen und treibt ausgangsseitig den Transformator 51, an den ausgangsseitig die Kontaktflächen 7 angeschlossen sind.

In Figur 3 ist ein zweites Ausführungsbeispiel des erfindungsgemäßen Prüfgeräts dargestellt. Die in Figur 3 dargestellte Ausführungsform unterscheidet sich von dem Ausführungsbeispiel aus Figur 2 nur durch die Art der Bereitstellung der Prüfspannung Vₚ. Es wird daher im Folgenden nur der unterschiedlich aufgebaute Zweig zur Bereitstellung der Prüfspannung Vₚ beschrieben. Ausgehend von der Versorgungsspannung V_{dd} wird durch einen Gleichspannungswandler 54 ein Spannungssignal erzeugt, das einen Spannungswert in der Größenordnung der Prüfspannung Vₚ aufweist. Durch das ausgangsseitige Signal des zweiten Verstärkers 94 aus dem Regelzweig wird das Spannungssignal durch ein Stellglied 55 geregelt und der Treiberstufe 52 zur Verfügung gestellt. Eingangsseitig ist der Treiberstufe 52 noch ein Kondensator 56 zur Glättung des Eingangssignals gegen Masse parallel geschaltet. Der Treiberstufe 52 wird des Weiteren das Taktsignal des Taktgenerators 53 zugeführt, so dass ausgangsseitig ein Signal mit der Prüfspannung Vₚ und Prüffrequenz fₚ abgreifbar ist.

### Bezugszeichenliste

- 1: Prüfgerät
- 3: Leuchtmittel
- 3a: Sockel
- 5: Bereitstellungsvorrichtung
- 7: Kontaktflächen
- 8: Messvorrichtung
- 9: Regelungsvorrichtung

- 51: Transformator
- 52: Treiberstufe
- 53: Taktgenerator
- 54: Gleichspannungswandler
- 55: Stellglied
- 56: Kondensator

- 91: Gleichrichter
- 92: erster Verstärker
- 93: Summationsstelle
- 94: zweiter Verstärker

- Vₙ: Nennspannung
- Vₚ: Prüfspannung
- Vₚₐ: angekoppelte Prüfspannung
- Vₚₘ: gemessene Prüfspannung
- fₙ: Nennfrequenz
- fp: Prüffrequenz
- fₚₐ: angekoppelte Prüffrequenz
- fₚₘ: gemessene Prüffrequenz
- V_{ref}: Referenzspannung
- V_{dd}: Versorgungsspannung

## Patentansprüche

1. Prüfgerät (1) für Leuchtmittel (3), die bei einer Nennspannung (Vₙ) und einer Nennfrequenz (fₙ) betrieben werden, mit kapazitiver Ankopplung einer Prüfspannung (Vₚ) mit einer Prüffrequenz (fₚ) an die Leuchtmittel (3),
**dadurch gekennzeichnet, dass**
eine angekoppelte Prüfspannung (Vₚₐ) der Nennspannung (Vₙ) entspricht und eine angekoppelte Prüffrequenz (fₚₐ) der Nennfrequenz (fₙ) entspricht.

2. Prüfgerät (1) nach Anspruch 1,
**dadurch gekennzeichnet, dass**
zur Ankopplung der Prüfspannung (Vₚ) isolierte Kontaktflächen (7) vorgesehen sind.

3. Prüfgerät (1) nach einem der vorhergehenden Ansprüche,
**dadurch gekennzeichnet, dass**
eine Messvorrichtung (8) zur Messung der angekoppelten Prüfspannung (Vₚₐ) vorgesehen ist.

4. Prüfgerät (1) nach einem der vorhergehenden Ansprüche,
**dadurch gekennzeichnet, dass**
eine Regelungsvorrichtung (9) zur Regelung der Prüfspannung (Vₚ) durch einen Vergleich einer gemessenen Prüfspannung (Vₚₘ) mit einer Referenzspannung (V_{ref}) vorgesehen ist.

5. Prüfgerät (1) nach einem der vorhergehenden Ansprüche,
**dadurch gekennzeichnet, dass**
eine Detektionsvorrichtung zur Detektion des Leuchtmittels (3) vorgesehen ist.

6. Prüfgerät (1) nach einem der vorhergehenden Ansprüche,
**dadurch gekennzeichnet, dass**
eine Änderungsvorrichtung vorgesehen ist, die die Prüfspannung (Vₚ) in einem Spannungsbereich und/oder die Prüffrequenz (fₚ) in einem Frequenzbereich verändert.

7. Prüfgerät (1) nach einem der vorhergehenden Ansprüche,
**dadurch gekennzeichnet, dass**
eine Erzeugungsvorrichtung (5) zur Erzeugung der Prüfspannung (Vₚ) aus einer Niedervolt-Energieversorgung (V_{dd}) vorgesehen ist.

8. Prüfgerät (1) nach Anspruch 7,
**dadurch gekennzeichnet, dass**
die Erzeugungsvorrichtung (5) einen Transformator (51) beinhaltet.

9. Prüfgerät (1) nach Anspruch 7,
**dadurch gekennzeichnet, dass**
die Erzeugungsvorrichtung (5) einen Gleichspannungswandler (54) beinhaltet.

10. Prüfgerät (1) nach einem der vorhergehenden Ansprüche,
**dadurch gekennzeichnet, dass**
zur Bereitstellung der Prüffrequenz (fₚ) ein Taktgenerator (53) vorgesehen ist.
